# FASCICULE DE BREVET EUROPEEN

(11) **EP 1 073 204 B1**
(45) Date de publication et mention de la délivrance du brevet: **16.06.2004**
(21) Numéro de dépôt: 00410085.5
(22) Date de dépôt: 28.07.2000
(51) Int. Cl.: H03L 7/06

(54) **Dispositif de synchronisation d'un événement de référence d'un signal analogique sur une horloge**
Anordnung zur Synchronisierung eines Bezugselements eines analogen Signals mit einem Taktsignal
Arrangement for synchronizing a reference event of an analog signal to a clock signal

(30) Priorité: 30.07.1999 FR 9910089
(43) Date de publication de la demande: 31.01.2001
(73) Titulaire: STMicroelectronics S.A., 92120 Montrouge (FR)
(72) Inventeur: Dautriche, Pierre, 38240 Meylan (FR)
(74) Mandataire: de Beaumont, Michel

(56) Documents cités:
- EP-A- 0 680 170
- GB-A- 2 310 772
- US-A- 5 553 104
- US-A- 5 646 968
- BATRUNI R ET AL: "MIXED DIGITAL/ANALOG SIGNAL PROCESSING FOR A SINGLE-CHIP 2B1Q U-INTERFACE TRANSCEIVER" IEEE JOURNAL OF SOLID-STATE CIRCUITS,US,IEEE INC. NEW YORK, vol. 25, no. 6, 1 décembre 1990 (1990-12-01), pages 1414-1425, XP000176570 ISSN: 0018-9200

## Description

La présente invention concerne un dispositif de synchronisation de signaux analogiques. Dans une application particulière on utilise plusieurs de ces dispositifs associés à plusieurs signaux analogiques respectifs dans le but de faire coïncider des événements de référence des signaux.

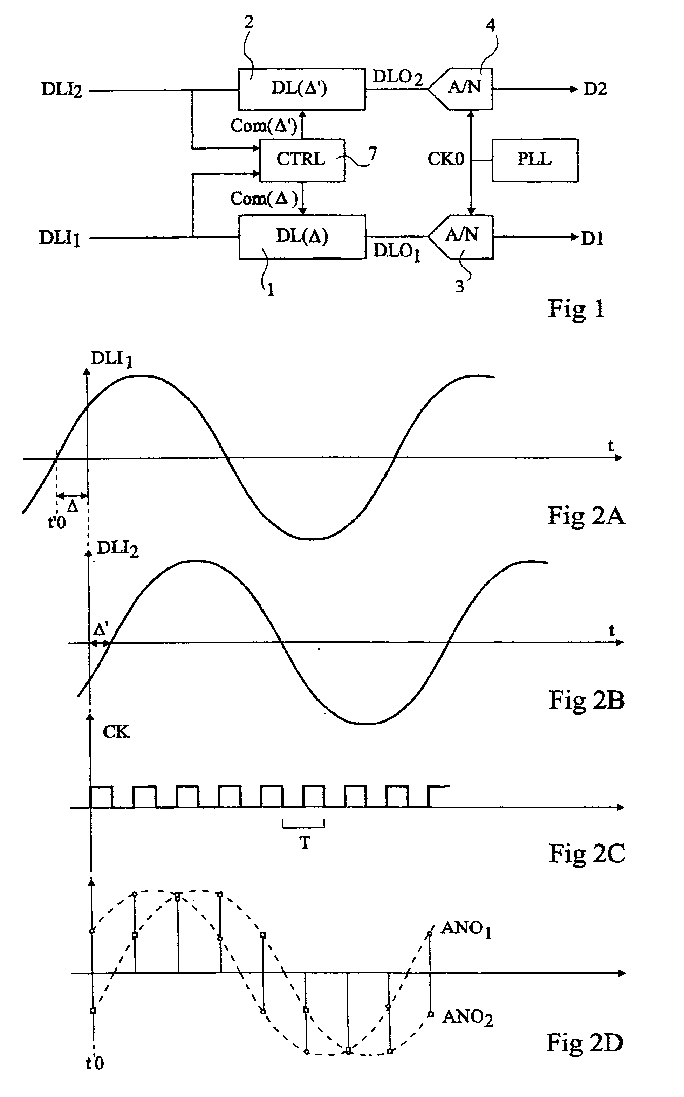

La figure 1 représente schématiquement un dispositif classique de synchronisation d'un événement de référence d'un signal analogique. Généralement, le dispositif est en outre prévu pour convertir le signal analogique synchronisé en un signal numérique.

Une ligne à retard programmable 1 reçoit un signal analogique DLI1, et fournit un signal analogique retardé DLO1 à un convertisseur analogique/numérique 3. Le convertisseur analogique/numérique 3 fournit des échantillons numériques D1 à la cadence d'un signal d'horloge CK0 produit par une boucle à verrouillage de phase 5. Une ligne à retard programmable 2 reçoit un signal analogique DLI2 et fournit un signal analogique retardé DLO2 à un convertisseur analogique/numérique 4. Le convertisseur analogique/numérique 4 fournit des échantillons numériques D2 à la cadence du signal d'horloge CKO. Les lignes à retard 1 et 2 sont respectivement programmées par des signaux de commande COM(Δ) et COM(Δ') produits par un circuit de commande 7 en fonction des signaux DLI1 et DLI2.

Dans un exemple, l'événement de référence est un passage par zéro du signal. Le circuit de commande 7 est alors prévu pour régler les lignes à retard 1 et 2 de manière que le passage par zéro du signal DLI1 soit synchronisé sur le passage par zéro du signal DLI2.

Les figures 2A à 2D illustrent le fonctionnement du dispositif de la figure 1. La figure 2A représente un signal analogique périodique DLI qui passe par 0 en un instant t0' en avance d'une durée Δ par rapport à un instant de référence t₀.

La figure 2B représente le signal DLI2. Ce signal DLI2 passe par zéro à l'instant t0 en retard d'une durée Δ' par rapport à l'instant de référence t0.

La figure 2C représente le signal d'horloge CK0 produit par la boucle à verrouillage de phase 5. L'instant de référence t₀ est fixé arbitrairement par un front montant du signal d'horloge CK0.

La figure 2D représente deux suites de valeurs numériques ANO1 et ANO2 échantillonnées lors des fronts montants successifs du signal CK0.

Le circuit de commande 7 fait évoluer les retards Δ et Δ' introduits par les lignes à retard entre les signaux DLO1 et DLO2 jusqu'à ce que le délai entre le passage par 0 du signal DLO1 et du signal DLO2 soit nul, ou le plus faible possible, selon ce que permet le pas de la ligne à retard.

Bien qu'un circuit tel que celui de la figure 1 fonctionne de manière satisfaisante, il présente plusieurs inconvénients notables. En particulier, un circuit numérique comportant une ligne à retard analogique programmable ne peut être réalisé que dans une technologie BiCMOS, coûteuse.

Les caractéristiques d'une ligne à retard, et en particulier son pas, peuvent changer considérablement si le processus de fabrication change. Ces variations de caractéristiques ne sont pas souhaitables.

D'autre part, une ligne à retard analogique est un élément délicat dont la moindre modification doit être réalisée avec le plus grand soin. C'est un élément dit "peu portable" d'une technologie de fabrication de circuit intégré à une autre.

Enfin, les techniques courantes ne permettent pas d'obtenir des lignes à retard programmables ayant un pas inférieur à un ordre de la nanoseconde.

Un objet de la présente invention est de réaliser un dispositif de synchronisation d'un événement de référence de plusieurs signaux analogiques, qui puisse être réalisé dans une technologie CMOS.

Un autre objet de la présente invention est de réaliser un tel dispositif de synchronisation dont les caractéristiques ne varient pas en fonction du processus de fabrication.

Un autre objet de la présente invention est de réaliser un tel dispositif de synchronisation qui soit facilement portable d'une technologie de circuit intégré à une autre.

Un autre objet de la présente invention est de réaliser un tel dispositif de synchronisation ayant un pas inférieur à la nanoseconde.

Pour atteindre ces objets, ainsi que d'autres, la présente invention prévoit un dispositif de synchronisation d'un événement de référence d'un signal analogique, qui comprend :
un convertisseur analogique/numérique recevant un signal d'entrée,
un registre recevant la sortie du convertisseur,
une boucle à verrouillage de phase comprenant un oscillateur produisant plusieurs signaux d'horloge déphasés de même période, un premier signal d'horloge cadençant le registre,
un multiplexeur recevant les autres signaux d'horloge sur des entrées respectives, dont la sortie cadence ledit convertisseur, et
un circuit d'analyse connecté pour commander le multiplexeur en fonction de valeurs successives de la sortie du registre.

Selon un mode de réalisation de la présente invention, l'oscillateur comprend un nombre pair d'amplificateurs différentiels équilibrés connectés en un anneau oscillant, une sortie d'un amplificateur de rang impair fournissant le premier signal d'horloge, et les sorties des amplificateurs de rang pair fournissant lesdits autres signaux d'horloge.

Selon un mode de réalisation de la présente invention, le circuit d'analyse comprend une mémoire pour stocker les valeurs successives du registre, et un microprocesseur pour analyser les valeurs successives afin de déterminer les instants de passage par zéro du signal de sortie du registre.

Selon un mode de réalisation de la présente invention, on prévoit un circuit comprenant plusieurs dispositifs de synchronisation tels que décrits précédemment, utilisant une unique boucle à verrouillage de phase et les mêmes signaux d'horloge.

Selon un mode de réalisation de la présente invention, on prévoit un circuit de commande d'un lecteur de disque laser tel que décrit précédemment, dans lequel chaque dispositif de synchronisation reçoit un signal analogique provenant d'une tête de lecture du disque.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1, décrite précédemment, représente un dispositif de synchronisation selon l'état de la technique ;
les figures 2A à 2D, décrites précédemment, illustrent le fonctionnement du dispositif de la figure 1 ;

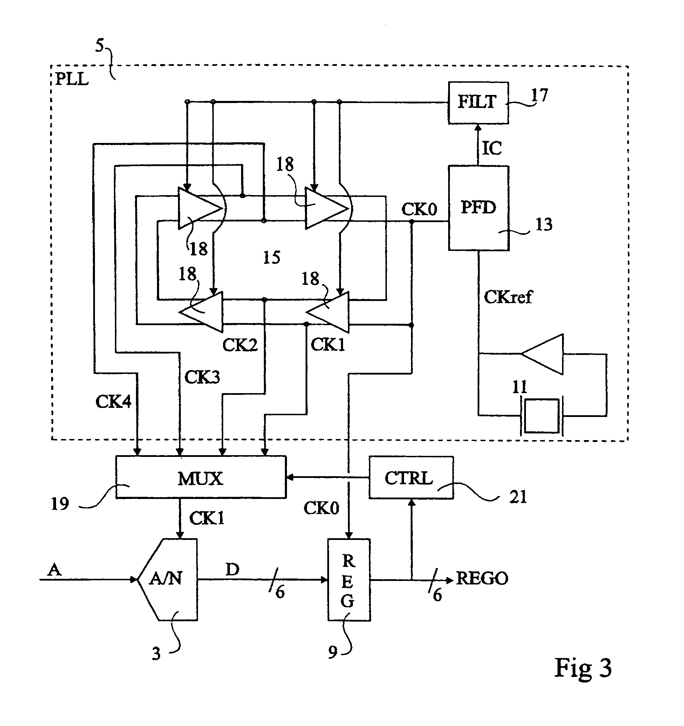

la figure 3 représente un dispositif de synchronisation selon la présente invention ;

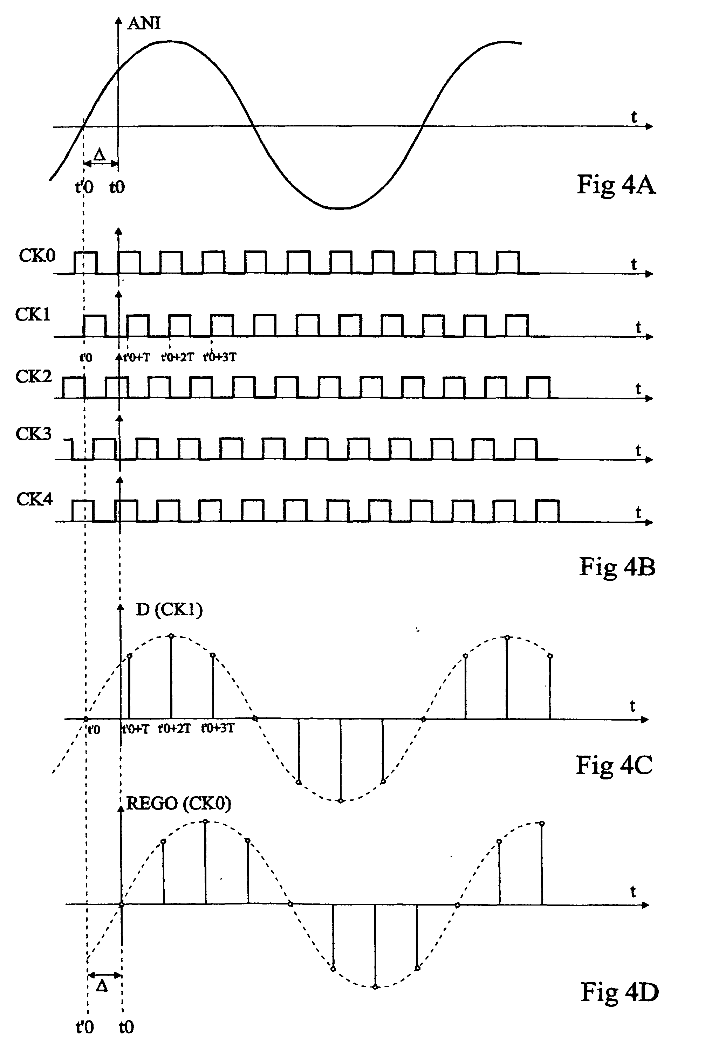

les figures 4A à 4D illustrent le fonctionnement du dispositif de la figure 3 ; et

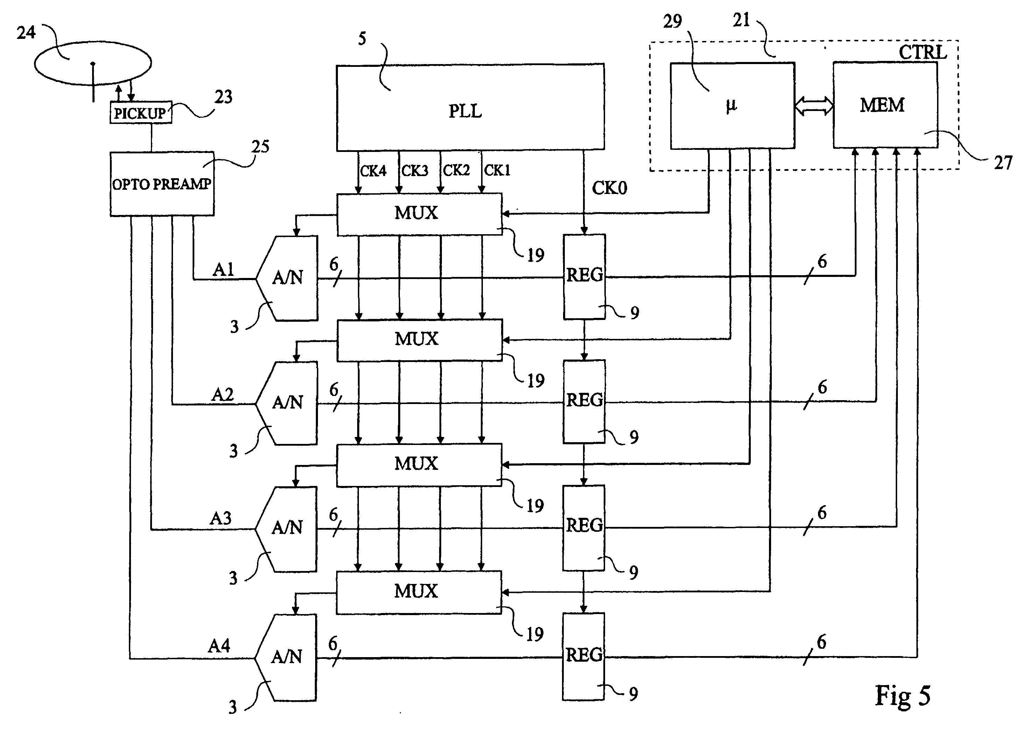

la figure 5 représente un circuit de traitement de signaux optiques, comprenant plusieurs dispositifs de synchronisation selon la présente invention.

La présente invention exploite la présence d'un convertisseur analogique/numérique pour atteindre le but visé. Au lieu de retarder un signal analogique au moyen d'une ligne à retard analogique programmable, on convertit immédiatement le signal analogique en numérique. Le retard programmable est obtenu grâce au convertisseur analogique/numérique que l'on cadence par un signal d'horloge de phase programmable. La sortie du convertisseur analogique/numérique est resynchronisée sur une horloge générale par un registre recevant la sortie du convertisseur.

La figure 3 représente schématiquement un dispositif de synchronisation selon la présente invention, comportant un convertisseur analogique/numérique 3 qui reçoit un signal analogique périodique A et qui fournit un signal numérique D à un registre 9. Une boucle à verrouillage de phase 5 comprend un oscillateur 11 fournissant une horloge de référence CKref. La boucle à verrouillage de phase 5 comprend en outre un comparateur de phase 13 dont la sortie IC commande un oscillateur 15 par l'intermédiaire d'un filtre passe bas 17. Le comparateur 13 est connecté pour comparer les phases de l'horloge de référence CKref et d'un premier signal d'horloge CK0 produit par l'oscillateur 15. Le registre 9 est cadencé par le signal d'horloge CK0.

L'oscillateur 15 comprend quatre amplificateurs différentiels équilibrés 18 connectés en un anneau oscillant. Une sortie d'un amplificateur de rang impair produit le premier signal d'horloge CK0. Des signaux d'horloge CK1 et CK2 sont produits par les sorties complémentaires d'un premier amplificateur de rang pair de l'oscillateur 15. De même, les signaux d'horloge CK3 et CK4 sont produits par les sorties complémentaires du second amplificateur de rang pair de l'oscillateur 15. Le filtre 17 commande le courant d'alimentation des amplificateurs et donc le temps de propagation de la boucle, correspondant à la période d'oscillation T. Les quatre signaux d'horloge CK1 à CK4 sont fournis à un multiplexeur 19. Le multiplexeur 19, dont la sortie cadence le convertisseur analogique/numérique 3, est commandé par un circuit d'analyse 21 qui reçoit la sortie REGO du registre 9.

Les figures 4A à 4D illustrent le fonctionnement du dispositif de la figure 3. La figure 4A représente un signal analogique périodique A qui passe par 0 à un instant t₀', une durée Δ en avance par rapport à un instant de référence t₀.

La figure 4B représente les signaux d'horloge CK0 à CK4. L'instant t₀ est défini par un front montant du premier signal d'horloge CK0, dont la période T est ici supérieure à la durée Δ. Les signaux d'horloge CK1 et CK3 sont déphasés l'un par rapport à l'autre d'un quart de la période T et le signal CK1 est décalé d'un huitième de la période T par rapport au signal d'horloge CK0. Aucune des horloges CK1 à CK4 n'est en phase avec le signal d'horloge CK0.

La figure 4C représente une succession d'échantillons numériques D produite par le convertisseur analogique/numérique 3, cadencé par les fronts montants successifs du signal d'horloge fourni par le multiplexeur 19.

La figure 4D représente une succession d'échantillons numériques D produite par le registre 9, cadencé par les fronts montants successifs du signal d'horloge CK0. Ces échantillons sont déphasés par rapport aux échantillons D de la différence de phase entre l'horloge CK0 et celle qui est fournie par le multiplexeur.

Le circuit d'analyse 21 détermine, comme on le verra par la suite, lequel des signaux d'horloge CK1 à CK4 présente le front montant le plus proche de l'instant t₀' de passage par zéro du signal A, et il commande le multiplexeur 19 pour le sélectionner. Dans l'exemple représenté, il sélectionne le signal CK1 dont un front montant se produit à l'instant t₀'. Ainsi cadencé, le convertisseur analogique/numérique 3 échantillonne le signal d'entrée A aux instants t0', t0'+T, t0'+2T, etc.

A l'instant t0', le registre 9 reçoit la valeur échantillonnée par le convertisseur 3, mais il ne la prend en compte qu'au front montant suivant de l'horloge CK0, à l'instant t0. De même, la valeur échantillonnée à l'instant t0'+T par le convertisseur 3 est prise en compte à un instant t0+T par le registre 9 et ainsi de suite. Il en découle que les valeurs successives prises par la sortie REGO du registre 9 correspondent effectivement à un échantillonnage du signal analogique A par le signal d'horloge CK0.

Par souci de clarté, dans l'exemple représenté, le signal d'horloge CK1 change exactement à l'instant t0', mais on notera qu'il peut également changer dans un intervalle de temps égal au plus petit décalage entre deux des signaux d'horloge CK1 à CK4, ici un quart de la période T. Au delà de cet intervalle de temps, le signal CK1 ne serait plus le signal dont le front montant est le plus proche de l'instant t0', et le circuit d'analyse 21 sélectionnerait un autre signal d'horloge. Ceci introduit une imprécision égale à cet intervalle de temps, qui correspond au pas du présent dispositif de synchronisation.

Si l'on souhaite synchroniser un signal analogique de manière plus fine, on peut diminuer ce pas en augmentant la fréquence du signal d'horloge de référence CKref ou bien prévoir un oscillateur 15 comportant un plus grand nombre d'amplificateurs différentiels équilibrés.

A titre d'exemple, un dispositif selon la présente invention utilisant un l'oscillateur 15 à huit amplificateurs différentiels et une horloge de référence à 112 MHz, permet de réaliser un dispositif de synchronisation ayant un pas de 1,16 nanosecondes. Ce pas sera divisé par deux si on utilise seize amplificateurs différentiels.

Si l'on veut retarder le signal A d'une durée Δ+nT, où n est un entier quelconque, il suffit de retarder le signal A de Δ comme décrit ci-dessus, puis d'ajouter en sortie du registre 9 une ligne à retard numérique de n étages cadencée à la période T.

On remarquera que le pas du dispositif de synchronisation selon la présente invention, égal à T/4 dans l'exemple présenté, ne dépend que de la fréquence 1/T de l'oscillateur 15 de la boucle à verrouillage de phase. Or cette fréquence ne dépend que de la fréquence de l'horloge de référence et non du processus de fabrication du dispositif.

Le dispositif selon la présente invention est composé uniquement d'éléments réalisables en technologie CMOS et faciles à transposer d'une technologie CMOS à une autre, ce qui rend le dispositif particulièrement portable.

La figure 5 représente une architecture d'un circuit de commande d'un lecteur de disque laser comprenant plusieurs dispositifs de synchronisation selon la présente invention. De mêmes références désignent des mêmes éléments qu'à la figure 3.

Un tel circuit permet par exemple d'intégrer un circuit de suivi (Tracking), classiquement réalisé en technologie BiCMOS, dans un circuit d'acquisition/asservissement du lecteur, classiquement réalisé en technologie CMOS. Le circuit de suivi reçoit de la tête de lecture du disque des signaux analogiques de centrage qui doivent être synchronisés sur une même horloge et transmis sous forme numérique à un microprocesseur du circuit d'acquisition/asservissement.

Dans l'exemple illustré, une tête 23 de lecture d'un disque laser 24 fournit quatre signaux analogiques A1 à A4 à un préamplificateur 25. Les signaux A1 à A4 sont fournis par le préamplificateur 25 à quatre convertisseurs analogique/numérique 3. Quatre multiplexeurs 19 cadencent respectivement les quatre convertisseurs analogique/numérique 3 et chacun reçoit les quatre signaux d'horloge déphasés CK1 à CK4 produits par une unique boucle à verrouillage de phase 5. Les signaux numériques produits par les convertisseurs analogique/numérique, resynchronisés par des registres respectifs 9, sont fournis à un circuit d'analyse unique 21. Les registres 9 sont cadencés par une horloge générale CK0 fournie par la boucle 5. Le circuit d'analyse 21 comprend une mémoire 27 dans laquelle est stocké un tableau des valeurs numériques produites par les registres 9. La mémoire 27 est reliée à un microprocesseur 29, qui fournit un signal de commande distinct à chacun des multiplexeurs 19 en fonction d'une analyse du tableau. L'horloge CK0 cadence également le microprocesseur 29 et la mémoire 27.

Le microprocesseur 29 utilise le tableau pour calculer au moyen d'algorithmes connus les instants de passage par 0 de chacun des signaux A1 à A4. Il compare les instants de passage par zéro aux fronts montants des signaux d'horloge CK1 à CK4, et commande en conséquence chaque multiplexeur 19 pour sélectionner l'un de ces signaux d'horloge, afin que les instants de passage par zéro des signaux numériques coincident les uns avec les autres.

Bien entendu, la présente invention est susceptible de diverses variantes et modifications qui apparaîtront à l'homme du métier. Par exemple, on a décrit en relation avec la figure 3 une boucle à verrouillage de phase utilisant uniquement les sorties des amplificateurs différentiels équilibrés de rang pair, mais il est possible d'utiliser les sorties de tous les amplificateurs différentiels équilibrés à l'exception de celle qui produit le premier signal d'horloge CK0. Une telle variante permettra de diminuer le pas du dispositif de synchronisation. D'autre part, les chronogrammes des figures 4A à 4D illustrent un cas où le convertisseur 3 et le registre 9 sont activés par des fronts montants des signaux d'horloge, mais on pourra également, au prix de modifications mineures, utiliser les fronts descendants des signaux d'horloge.

L'emploi d'amplificateurs opérationnels dans l'anneau oscillant décrit précédemment permet de diminuer la gigue des signaux produits par l'oscillateur en rejetant le bruit de mode commun. Cependant, on notera qu'on pourra également utiliser un autre type d'anneau oscillant pour l'oscillateur, utilisant par exemple un nombre impair d'inverseurs.

Enfin, la description précédente ne concerne que la synchronisation du passage par zéro d'un signal d'entrée, mais la présente invention est également applicable à la synchronisation d'un autre événement, comme le passage du signal d'entrée par une valeur maximale ou minimale.

## Revendications

1. Dispositif de synchronisation d'un événement de référence d'un signal analogique, **caractérisé en ce qu'**il comprend :
un convertisseur analogique/numérique (3) recevant un signal d'entrée (A),
un registre (9) recevant la sortie (D) du convertisseur,
une boucle à verrouillage de phase (5) comprenant un oscillateur (15) produisant plusieurs signaux d'horloge (CK0-CK4) déphasés de même période, un premier signal d'horloge (CK0) cadençant le registre (9),
un multiplexeur (19) recevant les autres signaux d'horloge (CK1-CK4) sur des entrées respectives, dont la sortie cadence ledit convertisseur, et
un circuit d'analyse (21) connecté pour commander le multiplexeur en fonction de valeurs successives de la sortie du registre.

2. Dispositif de synchronisation selon la revendication 1, **caractérisé en ce que** l'oscillateur comprend un nombre pair d'amplificateurs différentiels équilibrés connectés en un anneau oscillant, une sortie d'un amplificateur de rang impair fournissant le premier signal d'horloge (CK0), et les sorties des amplificateurs de rang pair fournissant lesdits autres signaux d'horloge (CK1-CK4).

3. Dispositif de synchronisation selon la revendication 1, **caractérisé en ce que** le circuit d'analyse (21) comprend une mémoire (27) pour stocker les valeurs successives du registre (9), et un microprocesseur (29) pour analyser les valeurs successives afin de déterminer les instants de passage par zéro du signal de sortie du registre.

4. Circuit comprenant plusieurs dispositifs de synchronisation selon l'une quelconque des revendications 1 à 3 utilisant une unique boucle à verrouillage de phase (5) et les mêmes signaux d'horloge (CK0-CK4).

5. Circuit de commande d'un lecteur de disque laser (24) selon la revendication 4, **caractérisé en ce que** chaque dispositif de synchronisation reçoit un signal analogique (A1-A4) provenant d'une tête de lecture (23, 25) du disque.

## Claims

1. A device for synchronizing a reference event of an analog signal, **characterized in that** it includes:
an analog-to-digital converter (3) receiving an input signal (A),
a register (9) receiving the converter output (D),
a phase-locked loop (5) including an oscillator (15) generating several phase-shifted clock signals (CK0-CK4) of same period, a first clock signal (CK0) clocking the register (9),
a multiplexer (19) receiving the other clock signals (CK1-CK4) on respective inputs, the output of which clocks said converter, and
an analysis circuit (21) connected to control the multiplexer according to successive values of the register output.

2. The synchronization device of claim 1, **characterized in that** the oscillator includes an even number of balanced differential amplifiers connected in an oscillating ring, an output of an amplifier of odd rank providing the first clock signal (CK0), and the outputs of the amplifiers of even rank providing said other clock signals (CK1-CK4).

3. The synchronization device of claim 1, **characterized in that** the analysis circuit (21) includes a memory (27) for storing the successive values of the register (9), and a microprocessor (29) for analyzing the successive values to determine the zero crossing times of the output signal of the register.

4. A circuit including several synchronization devices of any of claims 1 to 3, using a single phase-locked loop (5) and the same clock signals (CK0-CK4).

5. The circuit of claim 4 for controlling a laser disk reader (24), **characterized in that** each synchronization device receives an analog signal (A1-A4) coming from a pick-up head of the disk (23, 25).

## Patentansprüche

1. Vorrichtung zum Synchronisieren eines Bezugsereignisses bzw. -elements eines Analogsignals, **dadurch gekennzeichnet, daß** die Vorrichtung umfaßt:
einen Analog / Digital - Wandler ( 3 ), der ein Eingangssignal ( A ) zugeführt erhält.
ein Register ( 9 ), das die Ausgangsgröße des Wandlers zugeführt erhält,
eine phasenverriegelte Schleife ( 5 ) mit einem ersten Oszillator ( 15 ), der mehrere phasenversetzte Taktsignale ( CK0 - CK4 ) gleicher Periode erzeugt, wobei ein erstes Takisignal (CK 0 ) das Register ( 9 ) taktsteuert,
einen Multiplexer (19), der an entsprechenden Eingängen die anderen Taktsignale ( CK 1 - CK 4 ) zugeführt erhält, und dessen Ausgangsgröße den genannten Wandler taktsteuert, sowie
eine Analyseschaltung ( 21 ) in solcher Schaltverbindung, daß sie den Multiplexer in Abhängigkeit von aufeinanderfolgenden Werten der Ausgangsgröße des Registers steuert.

2. Synchronisiervorrichtung nach Anspruch 1, **dadurch gekennzeichnet, daß** der Oszillator eine geradzahlige Anzahl von symmetrischen bzw. Gegentakt- Differentialverstärkern aufweist, die als Oszillationsring geschaltet sind, daß ein Ausgang eines Verstärkers von ungeradem Rang das erste Taktsignal ( CK0 ) liefert, und daß die Ausgänge der Verstärker von geradzahligem Rang die genannten anderen Taktsignale ( CK1 - CK4 ) liefern.

3. Synchronisiervorrichtung nach Anspruch 1, **dadurch gekennzeichnet, daß** die Analyseschaltung ( 21 ) einen Speicher ( 27 ) zum Speichern der aufeinanderfolgenden Werte des Registers ( 9 ) aufweist sowie einen Mikroprozessor ( 29 ) zur Analyse der aufeinander folgenden Werte, um die Zeitpunkte des Nulldurchgangs des Ausgangssignals des Registers zu bestimmen.

4. Mehrere Synchronisiervorrichtungen nach einem der vorhergehenden Ansprüche 1 bis 3 enthaltende Schaltung, unter Verwendung einer einzigen Phasenverriegelungsschaltung ( 5 ) und derselben Taktsignale ( CK0 - CK4 ).

5. Steuerschaltung für eine Laser - Disketten- bzw. Ptatten - Leseeinrichtung ( 24) nach Anspruch 4 , **dadurch gekennzeichnet, daß** jede Synchronisiervorrichtung jeweils ein von einem Plattenlesekopf (23 , 25 ) herrührendes Analogsignal ( A1 - A4 ) zugeführt erhält.
